Europäisches Patentamt

European Patent Office

Office européen des brevets

(11) Veröffentlichungsnummer: **0 490 116 A2**

## EUROPÄISCHE PATENTANMELDUNG

(21) Anmeldenummer: **91119488.4**

(51) Int. Cl.5: **G01R 31/28**

(22) Anmeldetag: **15.11.91**

Die Anmeldung wird, wie ursprünglich eingereicht, unvollständig veröffentlicht (Art. 93 (2) EPÜ). Die Stelle der Beschreibung oder der Patentansprüche, die offensichtlich eine Auslassung enthält, ist als Lücke an der entsprechenden Stelle ersichtlich.

(30) Priorität: **12.12.90 DE 4039595**
**22.12.90 DE 4041492**

(43) Veröffentlichungstag der Anmeldung:
**17.06.92 Patentblatt 92/25**

(84) Benannte Vertragsstaaten:
**AT BE CH DE FR GB IT LI NL SE**

(71) Anmelder: **VDO Adolf Schindling AG**
**Gräfstrasse 103**
**W-6000 Frankfurt/Main 90(DE)**

(72) Erfinder: **Jagdt, Holger**
**Hamburger Strasse 38**
**W-6236 Eschborn(DE)**

(74) Vertreter: **Müller, Kurt, Dipl.-Ing.**
**Sodener Strasse 9**
**W-6231 Schwalbach/Taunus(DE)**

(54) **Verfahren zur Messung des Störpotentials eines IC.**

(57) Zur Messung des Störpotentials eines IC werden ein Verfahren und eine Meßanordnung vorgeschlagen, bei denen unter Verwendung eines induktionsarmen Widerstandes, einer Ersatzbeschaltung für den IC und einer allseitig abschirmenden Box reproduzierbare Meßwerte zur Beurteilung der EMV gewonnen werden können.

Fig.1

Die Erfindung bezieht sich auf ein Verfahren zur Messung des Störpotentials eines IC sowie auf eine Meßanordnung zur Durchführung des Verfahrens.

Elektronische Schaltungen (kurz IC) müssen auf ihre EMV (= elektromagnetische Verträglichkeit) geprüft werden, um ihr Störpotential für die Umgebung festzustellen und ggf. durch Änderung der Leitungsführung oder der Schaltung zu verkleinern. Umgekehrt will man auch wissen, welche äußeren Störeinflüsse u.U. kritisch sein können. Zur Ermittlung der EMV werden Strommessungen und darauf aufbauende Frequenzanalysen durchgeführt.

Dazu hat man bisher handelsübliche Nahfeldsonden benutzt, womit man jedoch nur ausnahmsweise brauchbare Ergebnisse erhält. Derartige Feldmessungen sind nämlich sowohl orts als auch layoutabhängig und ergeben deswegen keine reproduzierbaren Ergebnisse. Ein Vergleich verschiedener IC's ist auf dieser Basis nicht möglich. Die mit Nahfeldsonden meßbaren Werte eigenen sich deswegen auch nicht dazu, aus alternativ einsetzbaren IC's diejenigen mit der besseren EMV auszuwählen.

Man hat deswegen auch schon versucht, die EMV von IC's durch Strommessungen an einzelnen Pins unter Hochfrequenzgesichtspunkten zu bestimmen. Soweit dabei die Abstrahlung einzelner Stromschleifen oder die Abschlüsse von Wellenleitern bei Busstrukturen hinreichend gut simuliert werden konnten, ergeben sich zwar schon brauchbare Teilergebnisse, eine Gesamtbewertung des Störpotentials ist dabei aber nicht oder nur mit unvertretbar hohem Aufwand möglich.

Es besteht daher die Aufgabe, ein einfaches, kostengünstiges Verfahren anzugeben, mit dem das Störpotential eines IC reproduzierbar ermittelt werden kann, so daß die Ergebnisse für den Vergleich und die Auslegung von IC's im Hinblick auf die EMV brauchbar sind. Zur Lösung dieser Aufgabe wird erfindungsgemäß vorgeschlagen, daß man

a) den IC mit einer seinem Einsatzzweck entsprechenden Ersatzbeschaltung versieht und an die Versorgungsleitung einer Gleichspannungsquelle anschließt, die IC-seitig einen Abblockkondensator aufweist,

b) in einem Zweig der Versorgungsleitung zwischen IC und Abblockkondensator nahe beim IC einen induktionsarmen Widerstand mit den Anschlüssen P1 und P2 einsetzt,

c) alle Anschlüsse, über die IC-interne Ströme fließen, an den Punkt 1 und alle anderen Anschlüsse des IC über die Ersatzbeschaltung an P2 legt,

d) den IC zusammen mit der Gleichspannungsquelle in eine allseitig abschirmende Box einbringt und

e) mittels einer an P1 und P2 angeschlossenen Meßleitung den über den Widerstand fließenden Strom mißt.

Dabei wird der Widerstand zweckmäßigerweise in den Massepfad der Versorgungsleitung eingesetzt und der P1 zwischen IC und Widerstand gewählt. Als Meßleitung wird mit Vorteil ein Koaxial-Kabel verwendet, dessen Leiter an P1 und dessen

Abschirmung an P2 angeschlossen wird. Zur Messung des Störpotentials parasitärer Ströme eines IC wird das Verfahren dahingehend abgewandelt, daß man

a) den IC mit einer seinem Einsatzzweck entsprechenden Ersatzbeschaltung versieht und an die Versorgungsleitung einer Gleichspannungsquelle anschließt, die IC-seitig einen Abblockkondensator aufweist,

b) alle Anschlüsse des IC an einem Punkt P3 im Massepfad der Versorgungsleitung in der Nähe des IC zusammenfaßt,

c) an den P3 einen induktionsarmen Widerstand und den Leiter einer als Koax-Kabel ausgebildeten Meßleitung anschließt und den zweiten Anschluß des Widerstandes mit der Abschirmung des Koax-Kabels verbindet,

d) den IC zusammen mit der Gleichspannungsquelle in einer allseitig abschirmende Box einbringt und

e) den über den Widerstand fließenden Strom mißt.

In jedem Fall ist es vorteilhaft, wenn der Impedanzverlauf des Widerstandes über den interessierenden Frequenzbereich ermittelt wird und wenn die gewonnenen Meßergebnisse entsprechend dem Impedanzverlauf korrigiert werden. Man kann das Verfahren auch so durchführen, daß die Messung mit einem ersten und einem zweiten, vom ersten verschiedenen Widerstand durchgeführt wird und daß aus den dabei ermittelten Meßwerten ein korrigierter Meßwert gewonnen wird.

Zur Durchführung des Verfahrens benutzt man zweckmäßigerweise eine Meßanordnung, die gekennzeichnet ist durch

- eine allseitig abschirmende Box,
- einen in der Box mittig und von der Box isoliert angeordneten IC einschließlich Energiequelle,
- ein Meßgerät sowie
- eine Meßleitung mit
  - einem Leitungsteil innerhalb der Box, das zweiadrig oder als Koax-Kabel ausgebildet ist und dessen eine Ader bzw. dessen Abschirmung mit der Abschirmung der Box verbunden ist,
  - einer Durchführung durch die Wand der Box und

- einem Leitungsteil zwischen Box und Meßgerät, das aus einem Koax-Kabel besteht.

Weitere Ausgestaltungen der Meßanordnung sind in den Unteransprüchen 9 bis 15 beschrieben.

Das erfindungsgemäße Verfahren und die zugehörige Meßanordnung erlauben die Prüfung der EMV von IC's unter den ihrem Einsatzzweck entsprechenden Bedingungen, d.h. so wie sie schließlich eingesetzt werden sollen. Die Ersatzbeschaltung ermöglicht zum einen die Simulation der IC-Funktionen und zum anderen die Verwendung einer handlichen Meßanordnung. Damit erfüllt das Verfahren nicht nur alle technische Anforderungen, es ist auch sehr wirtschaftlich und erlaubt dem Schaltungsentwickler rasch und reproduzierbar für den jeweiligen Anwendungsfall geeignete IC's hinsichtlich ihrer EMV miteinander zu vergleichen.

Weitere Einzelheiten werden anhand des in den Fig. 1 bis 3 dargestellten Ausführungsbeispiels näher erläutert.

Fig. 1    zeigt einen IC mit einer realen Beschaltung,

Fig. 2    zeigt den IC nach Fig. 1 mit einer Ersatzbeschaltung,

Fig. 3    zeigt eine Schaltung zur Messung des Störpotentials der parasitären Ströme.

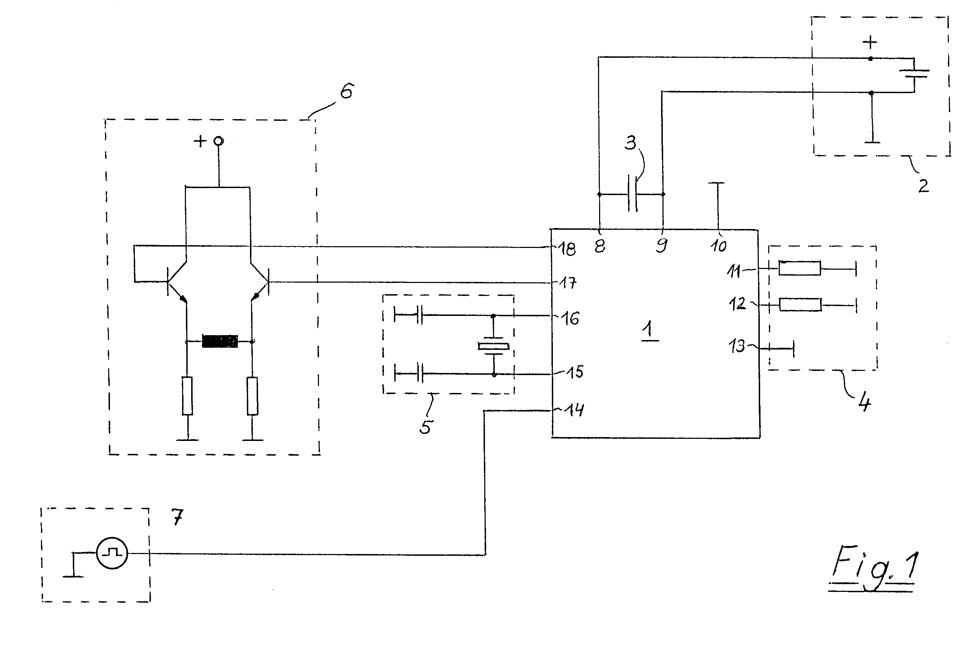

In Fig. 1 ist vereinfacht ein IC 1 mit den Anschlüssen 8 bis 18 für ein Beschaltungsbeispiel dargestellt. Die Anschlüsse 8 und 9 gehören zur Energieversorgung aus einer Gleichspannungsquelle 2, wobei üblicherweise wenigstens ein Abblockkondensator 3 als Ernergiespeicher vorgesehen ist. Anschluß 10 ist ein Masseanschluß, während die Anschlüsse 11 bis 13 als Kodierreingänge 4 vorgesehen sind. Anschluß 14 führt zu einem Signalgeber 7, die Anschlüsse 15 und 16 zu einer Oszillator-Beschaltung 5 und die Anschlüse 17 und 18 zur Ansteuerung 6 für einen Schrittmotor.

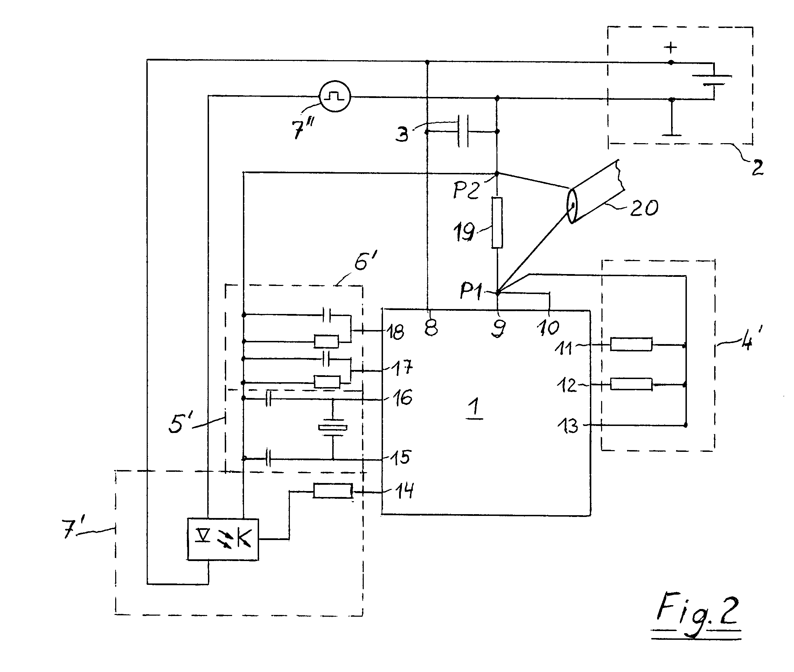

Fig. 2 zeigt den gleichen IC wie in Fig. 1 jedoch jetzt mit der zur Messung des Störpotentials angebrachten Ersatzbeschaltung und mit der erfindungsgemäßen Meßschaltung. Die Ersatzbeschaltung 4' für die Kodiereingänge ist zusammen mit dem Masseanschluß 10 auf den Punkt P1 gelegt. Damit sind die Anschlüsse zusammengefaßt, über die IC-interne Ströme fließen. Alle anderen Anschlüsse sind über die Ersatzbeschaltung (5', 6', 7', 7'') auf den Punkt P2 gelegt, wobei in den Massepfad der Versorgungsleitung (Anschluß 9) ein induktionsarmer Widerstand 19 zur Messung des für das Gesamt-Störpotential maßgebenden Störstrom eingesetzt ist. Die Ersatzbeschaltung für die Oszillator-Beschaltung 5' bzw. für die Schrittmotorsteuerung 6' ist verhältnismäßig einfach zu realisieren. Für den Signalgeber muß eine Ersatzbeschaltung 7', 7'' vorgesehen werden, die ein entsprechendes Signal erzeugen und störungsfrei in den IC eingeben kann. Dazu ist ein Signalgenerator 7'' und eine optische Einkopplung 7' vorgesehen. Über die Ausgänge 14 bis 18 fließen die nicht IC-internen Ströme.

Die Meßschaltung umfaßt außer dem Widerstand 19 noch die Meßleitung 20, deren Leiter an Punkt 1 und deren Abschirmung an Punkt 2 angeschlossen ist, eine Meßbox und ein Meßgerät (beide nicht dargestellt).

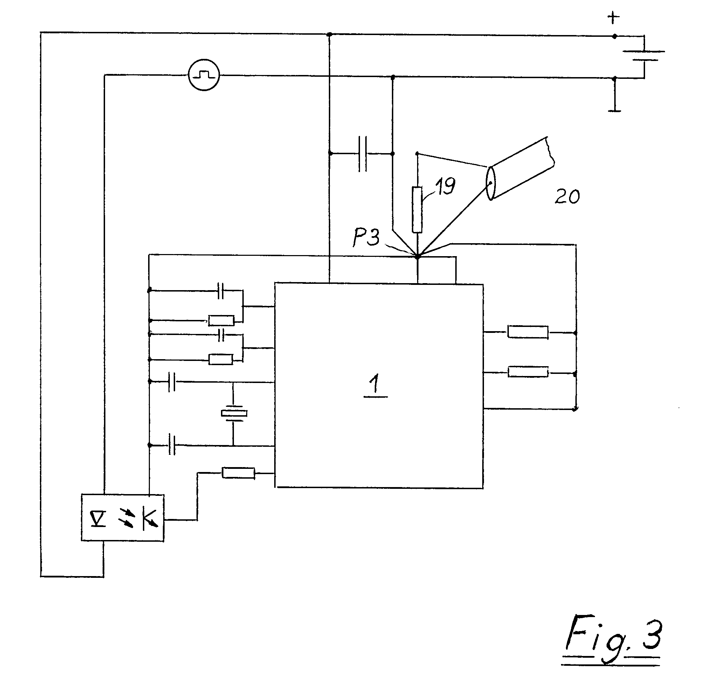

In Fig. 3 ist dargestellt, wie die Schaltung gemäß Fig. 2 zu modifizieren ist, wenn man das Störpotential der parasitären Ströme messen will. In diesem Fall werden alle Anschlüsse über die Ersatzbeschaltung auf einen Punkt P3 gelegt, der dem Punkt P1 in Fig. 2 entspricht. Außerdem wird hier der Massepfad der Versorungsleitung und der Widerstand 19 angeschlossen. Der Leiter der als Koax-Kabel ausgeführten Meßleitung wird ebenfalls an Punkt P3 angeschlossen, während die Abschirmung der Meßleitung an den freien Anschluß des Widerstandes 19 gelegt wird.

Mit den in den Fig. 2 und 3 dargestellten Schaltungen läßt sich also einmal das gesamte Störpotential des IC ermitteln und zum anderen unabhängig davon das Störpotential der parasitären Ströme. Die Meßanordnung ist sehr handlich und kann praktisch überall eingesetzt werden. Damit wird ein Verfahren und eine Vorrichtung zur Messung des Stör-potentials von IC's zur Verfügung gestellt, mit dem auf einfache und kostengünstige Weise Meßwerte zur Beurteilung der EMV von IC's gewonnen werden können, die representativ und reproduzierbar sind und zu einer vergleichenden Betrachtung verschiedener IC's unmittelbar herangezogen werden können.

Das erfindungsgemäße Verfahren und die zugehörige Meßanordnung können auch zur Messung der Ströme in elektronischen Schaltungen auf Leiterplatten oder auf abgetrennten Teilen von Leiterplatten verwendet werden.

**Patentansprüche**

1. Verfahren zur Messung des Störpotentials eines IC, dadurch gekennzeichnet, daß man

a) den IC mit einer seinem Einsatzzweck entsprechenden Ersatzbeschaltung versieht und an die Versorgungsleitungen einer Gleichspannungsquelle anschließt, zwischen denen IC-seitig einen Abblockkondensator angeordnet ist,

b) in eine der Versorgungsleitungen zwischen IC und Abblockkondensator nahe beim IC einen induktionsarmen Widerstand mit den Anschlüssen P1 zwischen dem Widerstand und dem IC und P2 zwischen dem Widerstand und dem Abblockkondensator einsetzt,

c) alle Anschlüsse, über die IC-interne Ströme fließen, an P1 und alle anderen Anschlüsse des IC über die Ersatzbeschaltung an P2 legt,

d) den IC zusammen mit der Gleichspannungsquelle in eine allseitig abschirmende Box einbringt und

e) mittels einer an P1 und P2 angeschlossenen Meßleitung den über den Widerstand fließenden Strom mißt.

2. Verfahren nach Anspruch 1, dadurch gekennzeichnet, daß der Widerstand in den Massepfad der Versorgungsleitung eingesetzt wird.

3. Verfahren nach einem der Ansprüche 1 oder 2, dadurch gekennzeichnet, daß als Meßleitung ein Koax-Kabel verwendet wird, dessen Leiter an P1 und dessen Abschirmung an P2 angeschlossen wird.

4. Verfahren zur Messung des Störpotentials parasitärer Ströme eines IC, dadurch gekennzeichnet, daß man

a) den IC mit einer seinem Einsatzzweck entsprechenden Ersatzbeschaltung versieht und an die Versorgungsleitungen einer Gleichspannungsquelle anschließt, zwischen denen IC-seitig einen Abblockkondensator angeordnet ist,

b) alle Anschlüsse des IC an einem Punkt P3 im Massepfad der Versorgungsleitung in der Nähe des IC zusammenfaßt,

c) an P3 einen induktionsarmen Widerstand und den Leiter einer als Koax-Kabel ausgebildeten Meßleitung anschließt und den zweiten Anschluß des Widerstandes mit der Abschirmung des Koax-Kabels verbindet,

d) den IC zusammen mit der Gleichspannungsquelle in einer allseitig abschirmende Box einbringt und e) den über den Widerstand fließenden Strom mißt.

6. Verfahren nach einem der Ansprüche 1 bis 5, dadurch gekennzeichnet, daß der Impedanzverlauf des Widerstandes über den interessierenden Frequenzbereich ermittelt wird und daß die gewonnenen Meßergebnisse entsprechend dem Impedanzverlauf korrigiert werden.

7. Verfahren nach Anspruch 6, dadurch gekennzeichnet, daß die Messung mit einem ersten und einem zweiten, vom ersten verschiedenen Widerstand durchgeführt wird und daß aus den dabei ermittelten Meßwerten ein korrigierter Meßwert gewonnen wird.

8. Meßanordnung für die Durchführung des Verfahrens nach den Ansprüchen 1 bis 7, gekennzeichnet durch

- eine allseitig abschirmende Box,

- einen in der Box mittig und von der Box isoliert angeordneten IC einschließlich Energiequelle,

- ein Meßgerät sowie

- eine Meßleitung mit

- einem Leitungsteil innerhalb der Box, das zweiadrig oder als Koax-Kabel ausgebildet ist und dessen eine Ader bzw. dessen Abschirmung mit der Abschirmung der Box verbunden ist,

- einer Durchführung durch die Wand der Box und

- einem Leitungsteil zwischen Box und Meßgerät, das aus einem Koax-Kabel besteht.

9. Meßanordnung nach Anspruch 8, dadurch gekennzeichnet, daß die größte Innenausdehnung der Box kleiner ist als die halbe Wellenlänge, die zu der höchsten interessierenden Störfrequenz gehört.

10. Meßanordnung nach Anspruch 8 oder 9, dadurch gekennzeichnet, daß die Länge des Leitungsteils innerhalb der Bog kleiner ist als ein Viertel der Wellenlänge, die zu der höchsten interessierenden Störfrequenz gehört.

11. Meßanordnung nach einem der Ansprüche 8 bis 10, dadurch gekennzeichnet, daß alle Teile der Meßleitung so ausgelegt sind, daß sie den gleichen Wellenwiderstand aufweisen wie der Meßgeräteeingang.

12. Meßanordnung nach einem der Ansprüche 8 bis 11, dadurch gekennzeichnet, daß der IC mit möglichst gleichmäßigem Abstand zu den gegenüberliegenden Wandungsteilen der Box positioniert ist.

13. Meßanordnung nach einem der Ansprüche 8 bis 12, dadurch gekennzeichnet, daß ein Widerstand verwendet wird, dessen Impedanz kleiner ist als ein Zehntel der Impedanz der Meßleitung bzw. der Quellenimpedanzen im Meß- und Strompfad.

14. Meßanordnung nach einem der Ansprüche 8 bis 13, dadurch gekennzeichnet, daß ein Widerstand verwendet wird, dessen Impedanz Z größer ist als der Quotient aus Rauschpegel des Meßgeräts und kleinstem zu messenden Strom ($Z > U_{rau}/I_{min}$).

15. Meßanordnung nach einem der Ansprüche 8 bis 14, dadurch gekennzeichnet, daß ein für die Oberflächenmontage ausgelegter, kleiner, hochfrequenztauglicher Widerstand mit bekanntem Impedanzverlauf verwendet wird.

16. Anwendung des Verfahrens nach den Ansprüchen 1 bis 7 bzw. der Meßanordnung nach den Ansprüchen 8 bis 15 zur Messung der Ströme in elektronischen Schaltungen auf Leiterplatten oder auf abgetrennten Teilen von Leiterplatten.

Fig.1

Fig.2

Fig. 3

EP 0 490 116 A2